# EUROPEAN PATENT APPLICATION

(11) **EP 4 668 259 A1**
(43) Date of publication of application: **24.12.2025**
(21) Application number: 25182035.3
(22) Date of filing: 11.06.2025
(51) Int. Cl.: G10H 3/18, G10H 1/46, H04R 3/00

(54) **ELECTRONIC DEVICE, METHOD, AND PROGRAM**

(30) Priority: 21.06.2024 JP 2024100161
(71) Applicant: Casio Computer Co., Ltd., Tokyo 151-8543 (JP)
(72) Inventor: Nozaki, Hikaru, Hamura-shi, Tokyo, 205-8555 (JP); Nagoya, Koyo, Hamura-shi, Tokyo, 205-8555 (JP); Kawamoto, Takumi, Hamura-shi, Tokyo, 205-8555 (JP)
(74) Representative: Grünecker Patent- und Rechtsanwälte PartG mbB

(57) **Abstract**

An electronic device includes: a current detection circuit (10, 20) that detects a current supplied from an adapter; and a processor (30) that processes a signal. The processor (30): clips the signal (S110) in a case where the current equal to or larger than a first threshold from the current detection circuit (10, 20) is continuously detected for a first time (S109: Yes), and outputs a clipped clip signal (I2S).

## Description

### CROSS-REFERENCE TO RELATED APPLICATIONS

The present application claims priority under Paris Convention to Japanese Patent Application No. 2024-100161, filed on June 21, 2024, the disclosure of which, including description, claims, abstract and drawings, is incorporated herein by reference in its entirety.

### TECHNICAL FIELD

The present disclosure relates to an electronic device, a method, and a program.

### RELATED ART

An overcurrent protection circuit incorporated in an adapter may stop power supply and shut down an electronic device.

An electronic device described in JP 2005-286546 A stops, when a large current is supplied from a power source to an amplifier, power supply in the line.

### SUMMARY OF THE INVENTION

An electronic device according to an embodiment of the present disclosure includes: a current detection circuit that detects a current supplied from an adapter; and a processor that processes a signal. The processor: clips the signal in a case where the current equal to or larger than a first threshold from the current detection circuit is continuously detected for a first time, and outputs a clipped clip signal.

### BRIEF DESCRIPTION OF THE DRAWINGS

FIG. 1 is a block diagram for describing a schematic configuration of an electronic musical instrument according to an embodiment of the present disclosure;
FIG. 2 is a graph illustrating an example of an operation of a clipper in the electronic musical instrument according to the embodiment of the present disclosure;
FIG. 3 is a block diagram illustrating a configuration of the electronic musical instrument according to the embodiment of the present disclosure;
FIG. 4 is a flowchart of clipping processing executed in the electronic musical instrument in the embodiment of the present disclosure; and
FIG. 5 is a diagram supplementing description of the flowchart illustrated in FIG. 4.

### DETAILED DESCRIPTION

In the configuration described in JP 2005-286546 A, since the power supply to the amplifier is stopped, there is a harmful effect such as interruption of output sound from a speaker, for example.

An embodiment of the present disclosure includes an electronic device suitable for preventing a product shutdown due to an adapter overcurrent protection function while preventing breakage of a speaker or the like due to a large current flow.

In the present disclosure, it is possible to avoid an overcurrent protection circuit of an adapter from being operated even at the time of excessive output of the amplifier, and to prevent an unexpected shutdown.

The following description relates to an electronic device, a method, and a program according to the embodiment of the present disclosure. Common or corresponding elements are denoted by the same or similar reference signs, and redundant description is appropriately simplified or omitted.

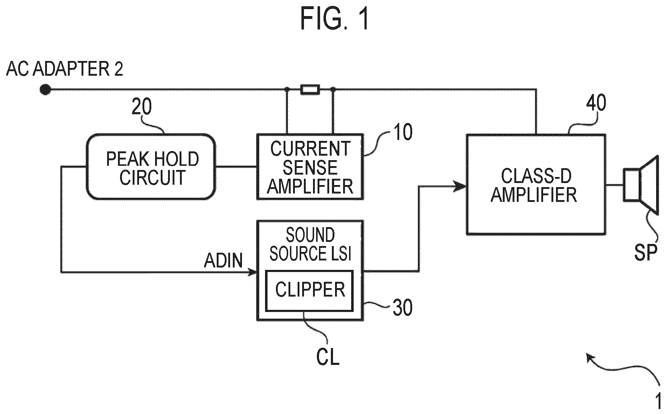

An electronic musical instrument 1 illustrated in FIG. 1 is an example of the electronic device and an example of a computer. The electronic musical instrument 1 is, for example, an electronic piano. The electronic musical instrument 1 may be an electronic keyboard instrument (for example, an electronic keyboard) other than the electronic piano, or may be another form of electronic musical instrument such as an electronic percussion instrument, an electronic wind instrument, or an electronic stringed instrument.

The electronic musical instrument 1 operates by power supplied from an AC adapter 2. The AC adapter 2 incorporates an overcurrent protection circuit. In the AC adapter 2, the overcurrent protection circuit operates when a current equal to or larger than a specified value (for example, 2.6 A) is continuously output for a specified time (for example, 70 ms). As a result, power supply to the electronic musical instrument 1 by the AC adapter 2 is stopped. Note that various numerical values indicated in the present embodiment are, for example, values determined on the basis of values of product specifications and design ideas, and are merely examples. These numerical values can be appropriately changed.

As schematically illustrated in FIG. 1, the electronic musical instrument 1 includes a current sense amplifier 10, a peak hold circuit 20, a sound source large scale integration (LSI) 30, a class-D amplifier 40, and a speaker SP.

The current sense amplifier 10 is installed on a power supply path from the AC adapter 2 to the class-D amplifier 40. The current sense amplifier 10 measures a drop voltage at a shunt resistor as a value indicating a consumption current in the class-D amplifier 40. That is, the current sense amplifier 10 is an example of a current detection circuit that detects a current supplied from the AC adapter 2.

The peak hold circuit 20 detects a peak value of a value measured by the current sense amplifier 10. Specifically, the peak hold circuit 20 holds a peak value of the drop voltage indicating the consumption current in the class-D amplifier 40, and outputs the peak value to an ADIN terminal of the sound source LSI 30. The peak hold circuit 20 is included in the current detection circuit that detects the current supplied from the AC adapter 2.

The sound source LSI 30 acquires the value indicating the consumption current in the class-D amplifier 40 from the peak value input to the ADIN terminal. The value indicating the consumption current is an example of a value indicating power supplied to an amplification unit.

The sound source LSI 30 includes a media player and a sound source module (not illustrated). The media player incorporates a codec corresponding to various formats. The media player can reproduce audio data in various formats. The reproduced audio data is amplified by the class-D amplifier 40 and output from the speaker SP. The audio data may be incorporated in the electronic musical instrument 1 or may be input from an external device connected in a wired or wireless manner.

The sound source module may include a digital signal processor (DSP) 34. In that case, the sound source module processes, for example, a performance operation on the electronic musical instrument 1 and various events (note-on, note-off, control change, and the like) corresponding to musical instrument digital interface (MIDI) data input from an external device. For example, when a note-on event corresponding to a key pressing operation is input, the sound source module reads corresponding waveform data. The sound source module generates digital musical sound data (for example, in an Inter-IC Sound (I2S) format) on the basis of the read waveform data. A musical sound signal generated by the sound source module is converted into an analog signal, then amplified by the class-D amplifier 40, and output from the speaker SP.

Hereinafter, for convenience of description, the audio data reproduced by the media player and the digital musical sound data generated by the sound source module may be collectively referred to as the "musical sound signal".

The sound source LSI 30 includes a clipper CL for preventing circuit breakage (for example, breakage of the speaker SP) when a large current flows in the electronic musical instrument 1. Note that each functional block in the sound source LSI 30 including the clipper CL is implemented by, for example, a software program. Each functional block of the sound source LSI 30 may be partially implemented by hardware such as a dedicated logic circuit.

In the electronic piano, for example, there are a case where an instantaneous high-level attack sound is produced, a case where a plurality of types of musical sound corresponding to a plurality of key pressing operations is simultaneously produced with a large volume, and a case where audio data with a high recording level is reproduced. In these cases, a large current flows, and a failure such as breakage of the speaker SP may occur.

In order to prevent the breakage of the speaker SP due to the large current, when the clipper CL is turned on to clip a peak of the musical sound signal, the musical sound signal is distorted and sound quality of output sound from the speaker SP is deteriorated. In this case, for example, a tone of the piano cannot be reproduced well. From a viewpoint of preventing the deterioration in the sound quality, it is desirable to avoid clipping the musical sound signal. From a viewpoint of protecting the speaker SP, it is necessary to clip a musical sound signal with a high level. It is desirable to prevent the deterioration in the sound quality while protecting the speaker SP.

Therefore, when the current sense amplifier 10 detects a current equal to or larger than a first threshold continuously for a first time, the sound source LSI 30 according to the present embodiment turns on the clipper CL to clip a musical sound signal, and outputs the musical sound signal as a clipped clip signal to the class-D amplifier 40. In other words, the sound source LSI 30 does not clip the musical sound signal until the current sense amplifier 10 detects the current equal to or larger than the first threshold continuously for the first time. Further in other words, the sound source LSI 30 does not clip the musical sound signal before an operation condition of the overcurrent protection circuit of the AC adapter 2 is satisfied (that is, while it is guaranteed that circuit breakage or the like does not occur). Therefore, for example, an instantaneous high-level attack sound is not clipped. Also in a case where a plurality of types of musical sound is instantaneously and simultaneously produced at a large volume, the clipper CL is not turned on, and the musical sound is not clipped. For example, even in the case of a piece of music with strong intonation, a tone of the piano can be reproduced well with high quality. Here, the tone is not limited to the tone of the piano.

The first threshold is, for example, 2.5 A. The first time is, for example, 50 ms. Therefore, before the operation condition of the overcurrent protection circuit of the AC adapter 2 is satisfied, the clipper CL is turned on and the musical sound signal is clipped. As a result, breakage of the speaker SP is prevented, and an unexpected shutdown of the electronic musical instrument 1 due to an operation of the overcurrent protection circuit of the AC adapter 2 is prevented.

A method of preventing breakage of the speaker SP by lowering a gain of the class-D amplifier 40 when a large current is detected is also conceivable. However, in a case where this method is adopted, when the large current is detected and the gain is lowered, a volume is rapidly lowered. Therefore, for example, performance sound may sound unnatural in a hearing sense. On the other hand, in the present embodiment, the gain of the class-D amplifier 40 is not lowered even in a case where a large current is detected. Therefore, a sudden decrease in the volume by lowering the gain does not occur. Even in a case where the large current is detected, a feeling of volume is maintained, so that unnatural performance sound is not generated.

In the electronic piano, it is rare that the performance sound continues at a large volume. Therefore, it is also rare that an operation condition of the clipper CL (that the current equal to or larger than the first threshold continues for the first time) is satisfied. However, there is a possibility that the performance sound continues at a large volume in a case where, for example, the electronic musical instrument 1 is played while audio data input from an external device is reproduced by the speaker SP of the electronic musical instrument 1. Therefore, in the present embodiment, breakage of the speaker SP is also prevented while substantially avoiding deterioration in the sound quality when the electronic piano is played.

Note that any reference to elements using designations such as "first", "second", and the like as used in the present disclosure does not generally limit an amount or order of those elements. These designations are used for convenience to distinguish between two or more elements. Therefore, for example, reference to first and second elements does not mean that only the two elements may be adopted, the first element must precede the second element, or the like.

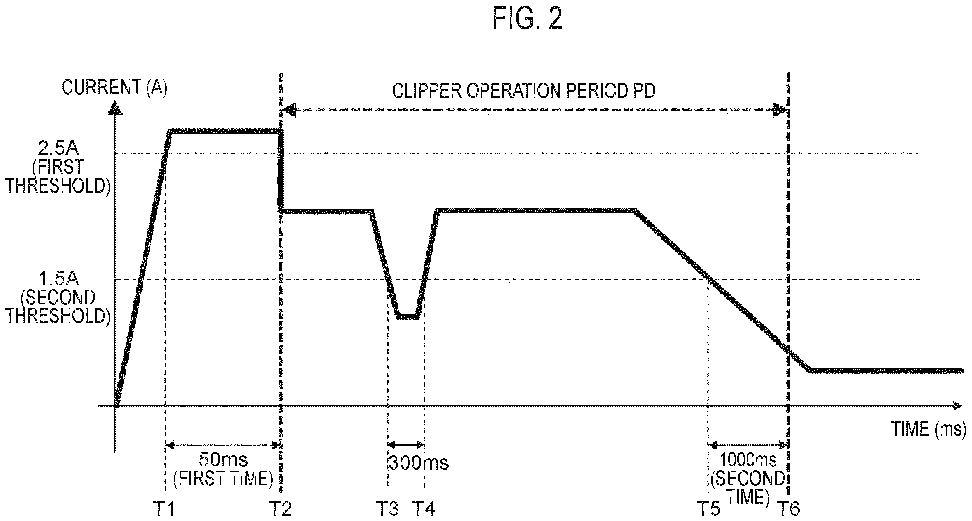

An example of an operation of the clipper CL will be described with reference to a graph of FIG. 2. A vertical axis in FIG. 2 indicates a current (unit: A) detected using the current sense amplifier 10. A horizontal axis in FIG. 2 indicates a time (unit: ms). Note that a scale of the time axis is appropriately changed. For example, 50 ms from a time point T1 to a time point T2 is indicated long in the drawing, while 300 ms from a time point T3 to a time point T4 and 1000 ms from a time point T5 to a time point T6 are indicated short in the drawing. In FIG. 2, a "clipper operation period PD" indicates a period from when the clipper CL is turned on to when the clipper CL is turned off.

In the example of FIG. 2, at the time point T2, the current of equal to or larger than 2.5 A (an example of the first threshold) is continuously detected for 50 ms (an example of the first time). Therefore, at the time point T2, the clipper CL is turned on, and a musical sound signal is clipped. A clip value is, for example, -9.28 dB. One advantage is that breakage of the speaker SP is prevented by clipping the musical sound signal.

It is conceivable to immediately turn off the clipper CL at a timing when the current decreases. Here, for example, in a case where a piece of music in which a change in intonation is large and fast is played, a vertical fluctuation of the current detected using the current sense amplifier 10 may become large. In this case, there is a possibility that the clipper CL is frequently turned on and off in accordance with the vertical fluctuation of the current. As a result, switching noise due to the clipper CL frequently turned on and off becomes conspicuous. The switching noise is an abnormal sound generated by switching between a sound distortion state caused by clipping a musical sound signal and a state where the musical sound signal is not clipped (a state where there is no sound distortion associated with clipping).

Therefore, when the current sense amplifier 10 detects a current equal to or smaller than a second threshold continuously for a second time during the period in which the musical sound signal is clipped, the sound source LSI 30 according to the present embodiment releases the clipping of the musical sound signal (turns off the clipper CL). The second threshold is lower than the first threshold, and is, for example, 1.5 A. The second time is longer than the first time, and is, for example, 1000 ms. Therefore, for example, during the period of 300 ms from the time point T3 to the time point T4, the current instantaneously falls below 1.5 A (an example of the second threshold), but the clipper CL is not turned off.

At the time point T6, the clipper CL is turned off only when the current of equal to or smaller than 1.5 A (an example of the second threshold) is continuously detected for 1000 ms (an example of the second time). By setting a release condition of the clipping in this manner, it is possible to avoid that the clipper CL is frequently turned on and off, and for example, it is possible to suppress occurrence of clip noise. In addition, in order to avoid that the clipper CL is frequently turned on and off, it is desirable to set the second time longer than the first time.

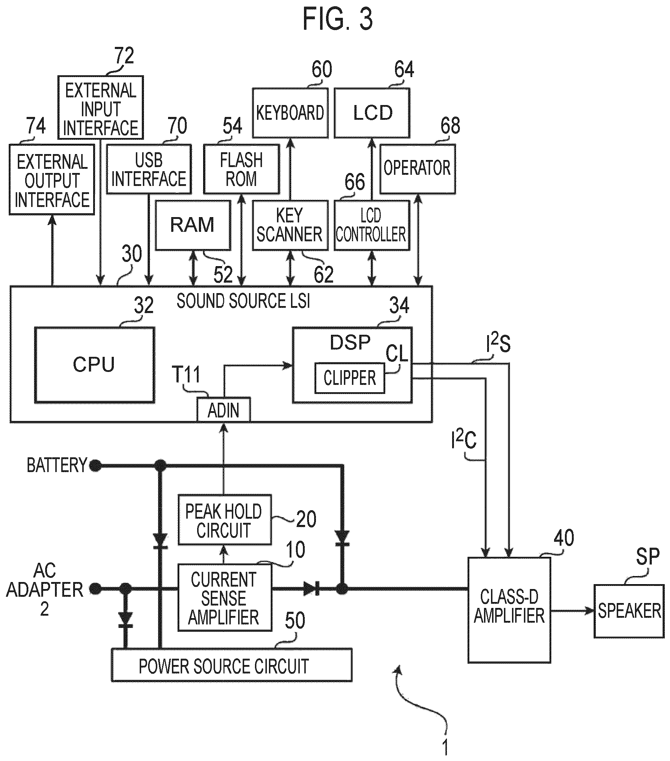

A specific configuration of the electronic musical instrument 1 will be described with reference to FIG. 3. As illustrated in FIG. 3, the electronic musical instrument 1 includes the current sense amplifier 10, the peak hold circuit 20, the sound source LSI 30, the class-D amplifier 40, a power source circuit 50, a random access memory (RAM) 52, a flash read only memory (ROM) 54, a keyboard 60, a key scanner 62, a liquid crystal display (LCD) 64, an LCD controller 66, an operator 68, a universal serial bus (USB) interface 70, an external input interface 72, an external output interface 74, and the speaker SP.

The power source circuit 50 generates power to be supplied to each unit of the electronic musical instrument 1 from power supplied from the AC adapter 2, and supplies the generated power to each unit.

The sound source LSI 30 is an example of a processor that processes a signal. More specifically, the sound source LSI 30 includes a central processing unit (CPU) 32 that controls each unit of the electronic musical instrument 1, and the DSP 34 that is an example of the processor. The CPU 32 reads a program and data stored in the flash ROM 54 and uses the RAM 52 as a work area to integrally control the electronic musical instrument 1. The CPU 32 also performs processing of, for example, outputting parameter setting such as a volume to the class-D amplifier 40 in an Inter-Integrated Circuit (I2C) format.

The RAM 52 temporarily holds data and a program. The RAM 52 holds a program and data (such as waveform data) read from the flash ROM 54 and other data necessary for communication.

The flash ROM 54 is a nonvolatile semiconductor memory such as a flash memory, an erasable programmable ROM (EPROM), or an electrically erasable programmable ROM (EEPROM).

The keyboard 60 is a keyboard including a plurality of white keys and black keys as a plurality of performance operators. Each key is associated with a different pitch. The electronic musical instrument 1 produces musical sound according to a key pressing operation on a key included in the keyboard 60.

The key scanner 62 monitors key pressing and key release on the keyboard 60. For example, when detecting a key pressing operation performed by a user, the key scanner 62 outputs a key pressing event to the sound source LSI 30. The key pressing event includes information (key number) regarding a pitch of a key related to the key pressing operation. The key number may also be referred to as a key number, a MIDI key, or a note number.

In the present embodiment, means for measuring a key pressing velocity (velocity) is separately provided, and the velocity measured by the means is also included in the key pressing event. Exemplarily, a plurality of contact switches is provided for each key. The velocity is measured by a difference in time during which each contact switch is conducted when the key is pressed. The velocity can also be said to be a value indicating a strength of the key pressing operation or a value indicating a loudness (volume) of the musical sound.

The LCD 64 is driven by the LCD controller 66. When the LCD controller 66 drives the LCD 64 according to a control signal from the CPU 32, a screen corresponding to the control signal is displayed on the LCD 64. The LCD 64 may be replaced with a display device such as an organic electro luminescence (EL).

The operator 68 includes various operators for operating the electronic musical instrument 1, such as a knob (such as a main volume knob), a button, and a pedal. The USB interface 70 is, for example, an interface for transmitting and receiving MIDI data (MIDI message) to and from an external MIDI device. The external input interface 72 is, for example, an audio interface to which an external device such as a microphone is connected. The external output interface 74 is, for example, an audio interface to which an external device such as an active speaker or a headphone is connected.

FIG. 3 merely illustrates an example of the configuration of the electronic musical instrument 1. For example, the speaker SP may be externally attached. Furthermore, the electronic musical instrument 1 may include other elements (for example, a switch panel, a touch device, or the like) not illustrated in FIG. 3. The electronic musical instrument 1 may be configured not to include a part of the elements illustrated in FIG. 3. In this manner, the configuration of the electronic musical instrument 1 has a degree of freedom in design, and there are various aspects.

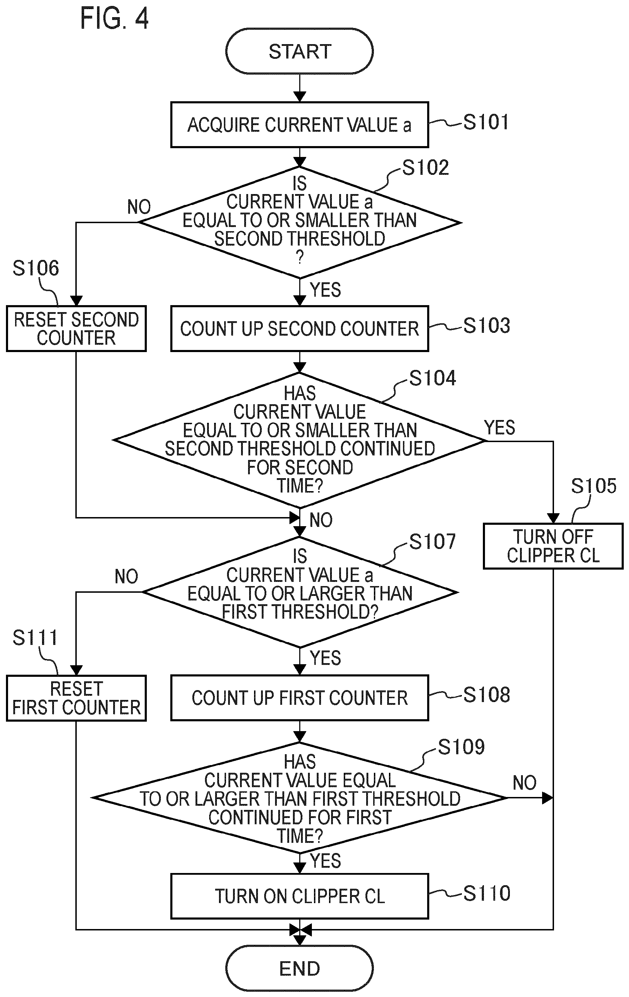

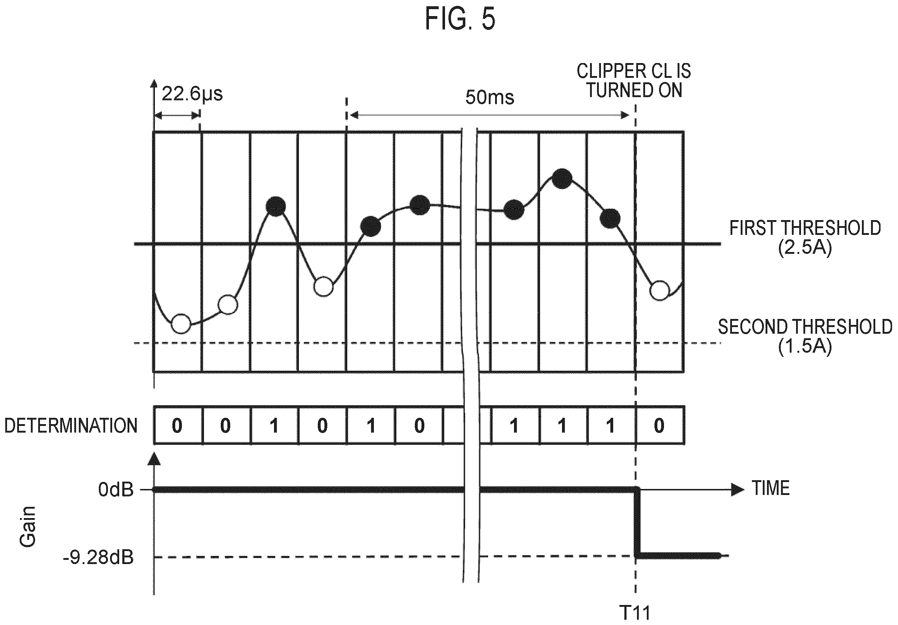

Clipping processing for a musical sound signal will be described with reference to FIGS. 4 and 5. A flowchart illustrated in FIG. 4 is executed at a predetermined cycle (for example, a cycle of 22.6 µs) by the DSP 34 that is an example of the processor, for example, from start to stop of a system of the electronic musical instrument 1.

Note that order of each step of the flowchart indicated in the embodiment of the present disclosure may be changed within a range without inconsistency. For example, in the embodiment of the present disclosure, the processing including various steps is presented using exemplary order, but the embodiment of the present disclosure is not limited to this presented order. Furthermore, the steps of the flowchart indicated in the embodiment of the present disclosure may be executed in parallel within a range without inconsistency.

As illustrated in FIG. 4, the DSP 34 acquires a current value a (step S101). Exemplarily, the DSP 34 converts a peak value input from the peak hold circuit 20 to an ADIN terminal T11 from an analog signal to a digital signal at a predetermined sampling rate, and acquires an average value for every n cycles (for example, every four times of sampling) as a value (current value a) indicating a consumption current in the class-D amplifier 40 (step S101). The number of samples used for calculation of the average value is appropriately set in consideration of, for example, suppression of variations in the peak value and delay associated with the calculation of the average value.

The DSP 34 determines whether or not the current value a is equal to or smaller than the second threshold (for example, 1.5 A) (step S102). Here, the DSP 34 includes a first counter and a second counter. The first counter is a counter used to determine whether or not the operation condition of the clipper CL is satisfied. The second counter is a counter used to determine whether or not an operation release condition of the clipper CL is satisfied. In a case where the current value a is equal to or smaller than the second threshold (step S102: YES), the DSP 34 counts up the second counter (step S103).

The DSP 34 determines whether or not the current value a equal to or smaller than the second threshold has continued for the second time (for example, 1000 ms) (step S104). Specifically, the DSP 34 determines whether or not a count value of the second counter has reached a value corresponding to the second time. In a case where the current value a equal to or smaller than the second threshold has continued for the second time (step S104: YES), the DSP 34 turns off the clipper CL (step S105) and ends this flowchart. In a case where the clipper CL is already in an OFF state, the processing of step S105 is not executed, and this flowchart ends.

In a case where the current value a equal to or smaller than the second threshold has not continued for the second time (step S104: NO), the DSP 34 proceeds to step S107. Furthermore, in a case where the current value a exceeds the second threshold (step S102: NO), the DSP 34 resets the second counter to 0 (step S106), and proceeds to step S107.

The DSP 34 does not release clipping of the musical sound signal until the current value a equal to or smaller than the second threshold is continuously detected for the second time. Therefore, it is possible to avoid that the clipper CL is frequently turned on and off, and for example, it is possible to suppress occurrence of clip noise. It is also possible to avoid the clipper CL is frequently turned on and off due to hunting or the like.

The DSP 34 determines whether or not the current value a is equal to or larger than the first threshold (for example, 2.5 A) (step S107). In a case where the current value a is equal to or larger than the first threshold (step S107: YES), the DSP 34 counts up the first counter (step S108).

The DSP 34 determines whether or not the current value a equal to or larger than the first threshold has continued for the first time (for example, 50 ms) (step S109). Specifically, the DSP 34 determines whether or not a count value of the first counter has reached a value corresponding to the first time. In a case where the current value a equal to or larger than the first threshold has continued for the first time (step S109: YES), the DSP 34 turns on the clipper CL (step S110) and ends this flowchart. In a case where the clipper CL is already in an ON state, the processing of step S110 is not executed, and this flowchart ends.

In a case where the current value a equal to or larger than the first threshold has not continued for the first time (step S109: NO), the DSP 34 ends this flowchart without executing the processing of step S110. Furthermore, in a case where the current value a is less than the first threshold (step S107: NO), the DSP 34 resets the first counter to 0 (step S111), and ends this flowchart.

The description of the flowchart of FIG. 4 will be supplemented with reference to FIG. 5. FIG. 5 illustrates processing results of FIG. 4 executed in the cycle of 22.6 µs side by side on a time axis. In FIG. 5, a black circle indicates that the current value a equal to or larger than the first threshold (2.5 A) is detected in the cycle processing. A white circle indicates that the current value a less than the first threshold is detected in the cycle processing. In the former case, a value 1 is obtained as a determination result, and in the latter case, a value 0 is obtained as the determination result.

In the example of FIG. 5, at a time point T11 when the current value a of equal to or larger than 2.5 A continues for 50 ms (in other words, the determination result of the value 1 continues the number of times corresponding to 50 ms), the clipper CL is turned on, and the musical sound signal is clipped at a clip value of - 9.28 dB. As a result, for example, breakage of the speaker SP can be prevented. The musical sound signal is not clipped until the time point T11 is reached (for example, until just before the operation condition of the overcurrent protection circuit of the AC adapter 2 is satisfied). Therefore, for example, it is possible to produce an instantaneous high-level attack sound or a plurality of types of instantaneous musical sound having a large volume with high quality without distortion. For example, even in the case of a piece of music with strong intonation, the tone of the piano can be reproduced well with high quality.

For example, in a configuration in which the CPU 32 performs on/off determination of the clipper CL, there is a possibility that the overcurrent protection circuit of the AC adapter 2 operates first due to a time lag from when on determination is performed to when the clipper CL of the DSP 34 is turned on. On the other hand, in the present embodiment, the peak value input to the ADIN terminal is directly input to the DSP 34 without passing through the CPU 32, and the DSP 34 performs the on/off determination of the clipper CL in real time. The DSP 34 directly performs the on/off determination of the clipper CL, so that the time lag described above is suppressed. The clipper CL is turned on before the overcurrent protection circuit of the AC adapter 2 operates, so that breakage of the speaker SP is prevented.

In the present embodiment, since a clip function is mounted on the DSP 34, for example, it is not necessary to provide a clip circuit in another circuit such as the class-D amplifier 40. Therefore, the electronic musical instrument 1 is suitably configured by more general-purpose electronic components.

The above is the description of the exemplary embodiment of the present disclosure. The embodiment of the present disclosure is not limited to that described above, and various modifications can be made within the scope of the technical idea of the present disclosure. For example, the embodiment of the present application also includes contents obtained by appropriately combining the embodiment and the like exemplarily specified in the specification or obvious embodiments and the like.

In the embodiment described above, the musical sound signal is clipped in the electronic musical instrument 1 to protect the speaker SP, but in another embodiment, a signal may be clipped in an electronic device other than the electronic musical instrument 1 to protect a circuit. Furthermore, in the embodiment described above, the current supplied from the AC adapter 2 is detected to perform the on/off determination of the clipper CL. In another embodiment, for example, on/off determination of the clipper CL may be performed by detecting a current supplied from a power source device of another form such as USB power delivery (USBPD). That is, the configuration according to the present disclosure can be applied not only to the AC adapter 2 but also to a case where a large current is prevented in a power source device of another form.

## Claims

1. An electronic device comprising:
a current detection circuit (10, 20) that detects a current supplied from an adapter; and
a processor (30) that processes a signal, wherein
the processor (30):
clips the signal (S110) in a case where the current equal to or larger than a first threshold from the current detection circuit (10, 20) is continuously detected for a first time (S109: Yes), and
outputs a clipped clip signal (I2S).

2. The electronic device according to claim 1, wherein
the processor (30):
releases clipping of the signal (S105) in a case where the current equal to or smaller than a second threshold smaller than the first threshold from the current detection circuit (10, 20) is continuously detected for a second time (S104: Yes) during a period of clipping the signal.

3. The electronic device according to claim 2, wherein
the second time is longer than the first time.

4. The electronic device according to claim 1, wherein
the processor (30) includes a digital signal processor (DSP) (34) that processes the signal.

5. The electronic device according to claim 4, wherein
the DSP (34) outputs the clip signal to an amplifier (40).

6. The electronic device according to claim 4, wherein
the current detection circuit (10, 20) includes a peak hold circuit (20),
an output from the peak hold circuit (20) is input to the DSP (34), and
the DSP (34) determines whether or not the current equal to or larger than the first threshold continues for the first time.

7. A method for causing an electronic device including: a current detection circuit (10, 20) that detects a current supplied from an adapter; and a processor (30) that processes a signal, to execute processing comprising:
clipping the signal (S110) in a case where the current equal to or larger than a first threshold from the current detection circuit (10, 20) is continuously detected for a first time (S109: Yes); and
outputting a clipped clip signal (I2S).

8. The method according to claim 7, wherein
the processing includes:
releasing clipping of the signal (S105) in a case where the current equal to or smaller than a second threshold smaller than the first threshold from the current detection circuit (10, 20) is continuously detected for a second time (S104: Yes) during a period of clipping the signal.

9. The method according to claim 8, wherein
the second time is longer than the first time.

10. The method according to claim 7, wherein
the processor (30) includes a digital signal processor (DSP) (34) that processes the signal.

11. The method according to claim 10, wherein
the DSP (34) outputs the clip signal to an amplifier (40).

12. The method according to claim 10, wherein
the current detection circuit (10, 20) includes a peak hold circuit (20),
an output from the peak hold circuit (20) is input to the DSP (34), and
the DSP (34) determines whether or not the current equal to or larger than the first threshold continues for the first time.

13. A program for causing an electronic device including: a current detection circuit (10, 20) that detects a current supplied from an adapter; and a processor (30) that processes a signal, to execute processing comprising:
clipping the signal (S110) in a case where the current equal to or larger than a first threshold from the current detection circuit (10, 20) is continuously detected for a first time (S109: Yes); and
outputting a clipped clip signal (I2S).
